Europäisches Patentamt

European Patent Office

Office européen des brevets

(19)

(11) **EP 1 578 018 A1**

(12) **EUROPEAN PATENT APPLICATION**

(43) Date of publication:
   **21.09.2005 Bulletin 2005/38**

(51) Int Cl.$^7$: **H03K 19/003**

(21) Application number: **04447067.2**

(22) Date of filing: **18.03.2004**

(84) Designated Contracting States:
   **AT BE BG CH CY CZ DE DK EE ES FI FR GB GR
   HU IE IT LI LU MC NL PL PT RO SE SI SK TR**
   Designated Extension States:
   **AL LT LV MK**

(71) Applicants:
   • **INTERUNIVERSITAIR MICROELEKTRONICA
      CENTRUM VZW
      3001 Leuven (BE)**
   • **Lea ABC
      2000 Antwerpen (BE)**

(72) Inventors:
   • **Wouters, Jan
      3020 Herent (BE)**
   • **Sevenhans, Jan
      2930 Brasschaat (BE)**

(74) Representative: **Van Malderen, Joelle et al
      pronovem - Office Van Malderen
      Avenue Josse Goffin 158
      1082 Bruxelles (BE)**

(54) **Low voltage driver**

(57)   The present invention is related to a driver circuit comprising an input, an output and at least one low-ohmic switch. The switch is provided with an input terminal and two output terminals. The driver circuit further comprises a first feedback arrangement in a low-voltage CMOS technology, inputting the voltage of one output terminal of the switch and steering the input terminal of the switch to keep the voltage of that one output terminal within a predefined range, whereby the predefined range is characterised by a threshold value.

Fig.1

## Description

### Field of the invention

The present invention is related to a low voltage driver circuit.

### State of the art

A low voltage driver implemented as an open drain output, essentially contains just a switch to ground. This switch can be either on or off. The load is a coil (which is the driving coil of a relais). When such an inductive load is present, things get somewhat more complicated: when the switch gets disabled, the coil free wheels, and hence a flyback mechanism must be implemented to control the behaviour (i.e. to control the pin voltage). Some additional requirements on the driver circuit are :

- on chip power dissipation to be taken into account
- pin voltage slope control
- over-current protection

This implies that the flyback diode must be available in the technology used (e.g. in CMOS) and/or that a high-voltage technology must be used.

In document 'A Dual *High-current high-voltage Driver', R.Shields & R.Pease, IEEE Journal of solid-state circuits, Vol.29, No.10, October 1994,* a high-current driver is disclosed wherein inductively-induced flyback voltage transients are clamped internally to safe voltages. The overload condition is dealt with by switching off the driver circuitry. At the next rising edge of the control input all internal monitoring circuitry is reset and the output is switched on.

In *Power+ Logic Methodology applied to a six output power driver, A.Marshall & F.Caravajal, IEEE 1993 Bipolar Circuits and Technology Meeting,* the integrated circuit will cycle on and off at a low duty cycle, if an output load becomes short-circuited.

### Aims of the invention

The present invention aims to provide a low voltage driver, implemented in a low-voltage CMOS, technology that provides flyback protection, over-current protection and slope control.

### Summary of the invention

The invention relates to a driver circuit comprising an input, an output and at least one low-ohmic switch. This switch is provided with an input terminal and two output terminals. The driver circuit further comprises a first feedback arrangement in a low-voltage CMOS technology, inputting the voltage of one output terminal of the switch. Said first feedback arrangement steers the input terminal of said switch to keep the voltage of said one output terminal within a predefined range, which is characterised by a threshold value.

In a preferred embodiment the first feedback arrangement is operative only when the voltage of said one output terminal reaches said threshold value.

The first feedback arrangement advantageously comprises an active component.

Preferably the first feedback arrangement comprises an asymmetric operational amplifier, whereby one input of the operational amplifier is connected to the voltage of said one output terminal and whereby the output of the operational amplifier steers the input terminal of the switch.

In a typical embodiment the first feedback arrangement comprises means for providing a voltage reference, which is used for setting said threshold value.

The low-ohmic switch preferably is made in a low-voltage CMOS technology.

In an advantageous embodiment the driver circuit further comprises a second feedback arrangement inputting the voltage of the one output terminal of the switch and steering the input terminal of the switch to keep the voltage slope at the output terminal within a predefined range.

The second feedback arrangement typically is passive. It can for example comprise a capacitor.

In another preferred embodiment the second feedback arrangement further comprises a resistor. Alternatively, a current source can perform the function of loading the capacitor.

Advantageously the driver circuit further comprises a third feedback arrangement steering the input terminal of the switch to keep the current through the switch within a predefined range.

The third feedback arrangement further comprises a logical circuit driving the input terminal of the switch into a low-current state when the driver circuit input and the voltage of the one output terminal indicate a current through said switch outside said predefined range. The latter 'and' is to be understood as a logical 'and'.

In a preferred embodiment the third feedback arrangement reuses the above-mentioned resistor.

### Short description of the drawings

Fig. 1 represents a general block diagram of a low voltage driver according to the invention.

Fig. 2 represents a scheme showing the over-current protection principle.

Fig. 3 represents some simulation results showing the driver behaviour in case it is switched on.

Fig. 4 represents some simulation results showing the driver behaviour in case it is switched off.

## Detailed description of the invention

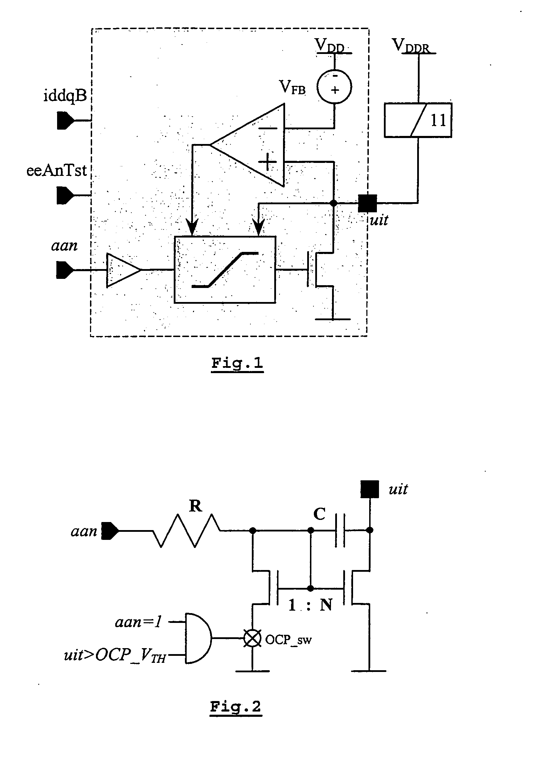

Fig.1 represents a general block diagram of a low voltage driver according to the invention. It has an open drain output, essentially containing just a switch to ground. The switch can either be on or off. The driver switch is on when *aan = 1*. The current output of the cell is at pin uit. From a digital point of view the cell is inverting : uit is the inverse of *aan*. Uit is used as an input for a flyback protection circuit, the over-current protection circuit and the slope control block. It is an essential feature of present invention that the complete flyback protection circuit is carried out in CMOS technology.

The current through the driver is mainly set by the coil (11) series resistance $R_L$. Indeed, the switch-on resistance $R_S$, including all pin-to-pin parasitic series resistances, is significantly less than $R_L$.

The driver circuit performs a slope control function. A maximum pin voltage slope is required in order to limit the generated EMI (ElectroMagnetic Interference). The pin voltage slope is realised in the following way. A capacitance C is put between the drain (this is the pin or the driver output) and the switch transistor gate. A series resistance R is inserted between the transistor gate and the driving (digital) buffer. These elements are shown in Fig.2. The result is a large-signal slew rate control: the drain voltage (i.e. the pin) can only change with a rate that is equal to the rate with which the capacitor's voltage changes, and this change is set by the current through the resistor R and charging the capacitor C.

The circuit of Fig.2 comprises a capacitive voltage feedback mechanism from drain to gate. E.g., when the switch goes off, the pin voltage will rise, driven by the free-wheeling coil. But due to the capacitor this will also pull up the gate of the switch, again switching on the switch. This will counter the pin voltage rise. One recognises a negative feedback mechanism. The pin voltage can only change when the voltage across the capacitor C changes. As a result, it can be seen that the pin slope (in V/s) equals I/C, I being the current through the resistor and flowing into (i.e. charging) the feedback capacitor C. I is equal to V/R, V being the voltage across the gate series resistor R. Assuming as example a current $I_L$ of 30 mA, V is approximated as follows:

- switch going off: $V = V_G$-ground = $V_{TN}+V_{eff}$ ($I_{switch}=I_L$=30 mA)
- switch going on: $V = V_{DD}-V_G = V_{DD}-V_{TN}$ ($I_{switch} = I_L = 0$) $V_G$ denotes the transistor gate voltage and $V_{TN}$ the transistor threshold, which is roughly 1 Volt. $V_{eff}$ is the overdrive voltage or $V_{GS}-V_T$, required to get the 30 mA through the transistor. From this it is also seen that the rising and falling slopes are somewhat different. The slope is fully determined by the silicon (and $V_{DD}$).

The driver also needs an over-current protection (OCP). Indeed, when the switch is on and the output pin is shorted to $V_{DD}$, excessive current and power can result (potentially damaging the chip) if no preventive measures are taken.

When the driver is on (input *aan* equals '1'), it can be in two different states:

- the *normal-on state.* The switch is fully on and essentially behaves like a low impedant resistor. The current is mainly set by the external load resistance. This state occurs when the pin voltage < OCP_$V_{TH}$.
- the *over-current state.* The switch behaves like a current source with value OCP_I. The external load hardly influences the current. The current is set/limited by the silicon (to OCP_I). This occurs when the pin voltage > OCP_$V_{TH}$.

A typical value for OCP_$V_{TH}$ can be $V_{DD}$/2.

An alternative solution could have been to directly measure the current and limit the current to a certain maximum. However, this gives the following problem. When all is normal and the driver is on, about 30 mA flows (in the present example). Hence the over-current limit would need to be higher than 30 mA. But then the other extreme of the limit would be, say, 100 mA (due to process tolerances, temperature dependencies etc.). Hence in a worst case switch power dissipation would be 100 mA times 5 V (suppose pin is shorted to $V_{DD}$), so 500 mW, which is simply too much for one driver.

The actual implementation allows setting an over-current limit OCP_I that is different from (actually, lower than) the normal current. OCP_I is defined to be so that the dissipation in the switch during an over-current condition is of the same order of magnitude as the switch dissipation when a coil is connected and the switch is on. Fig. 2 schematically shows the principle. One recognises the two '*aan* equals 1' states:

- the normal-on state: when switch OCP_sw (see Fig. 2) is off, the switch transistor gate finally goes to $V_{DD}$; the switch is fully on.
- the over-current state: when switch OCP_sw is on, both transistors realise a current mirror (the switch itself *is* in saturation). The switch current then is the over-current current. Clearly:

$$OCP\_I = \frac{V_{DD}-V_{TN}}{R} \cdot N$$

where $V_{TN}$ denotes the nmos threshold, N the current mirror ratio (see Fig.2; N » 1). R is the resistor as defined in Fig.2.

It is important to note that the resistor R serves two totally different purposes:

- it helps setting the pin voltage slew rate (cfr. supra)
- R helps setting OCP_I

Obviously both are important design equations.

OCP_$V_{TH}$ should not be set too low: in the normal-on state with a coil as load, the pin (DC) voltage should never reach this threshold. In a worst case the pin DC voltage can be rather high.

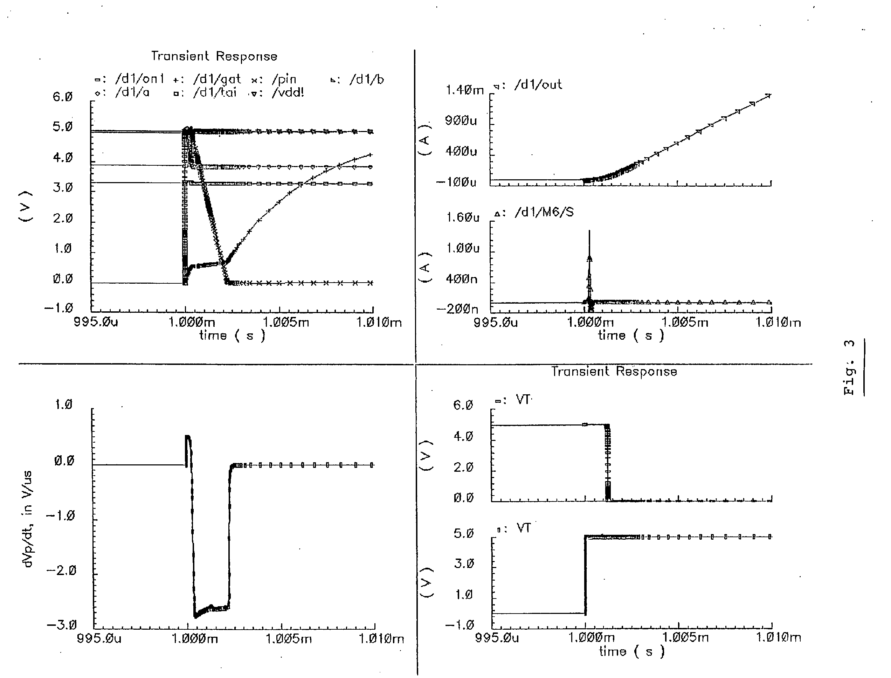

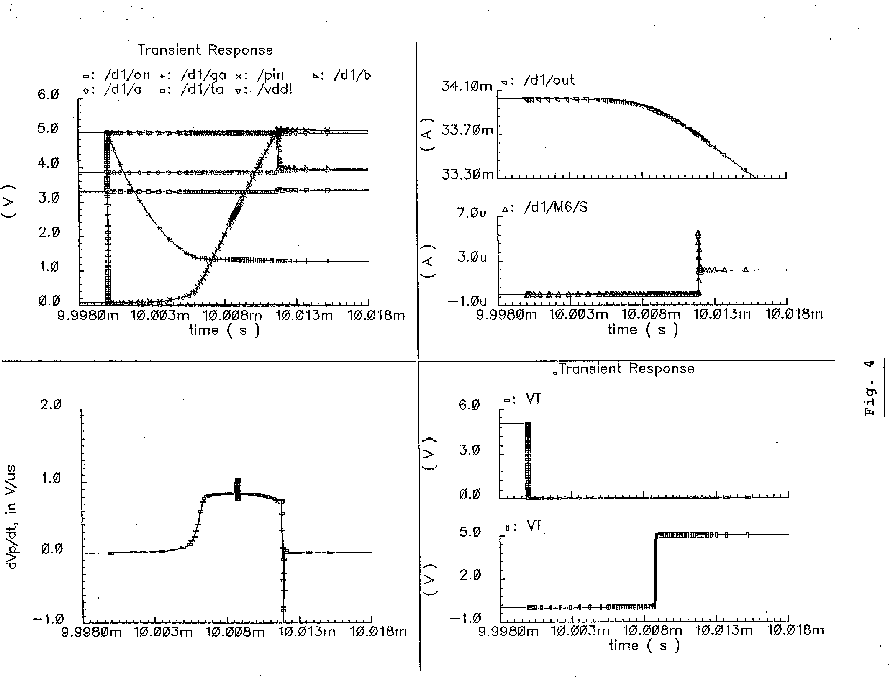

From a DC point of view, the AND gate in Fig. 3 is not required. This condition for enabling the OCP_sw switch is required for the following reason. Suppose a coil is connected and the driver goes off (and there are no shorts). The pin voltage will rise fast (but slope-controlled) to $V_{DD}$ and the current will decay slowly. Hence a big current and a high pin voltage will, temporarily, result. This is just as if there were over-current (or better, over-power). But this is normal and has to be like that, as this situation does not last long. Without the '*aan* equals 1' condition, the OCP circuit would be activated. However, limiting the switch current is certainly not allowed during this transient. The OCP circuit would even compete with the flyback circuit (which keeps the coil current flowing through the switch during this transient). With the condition included: because *aan* is '0', the OCP circuit will not (and should not) be triggered. The condition hence is required to avoid problems during normal transient. Or a different, but equivalent view: *aan* acts immediately through the AND, while action through the resistor R and the flyback circuit would take a significant time. The lower-right graph of Fig.4 shows the AND inputs.

When a coil is connected and the switch gets activated, the pin voltage is initially high. This voltage then drops linearly (pin voltage slope control) to ground and the current ramps up (starting from zero). The voltage ramp is much faster than the current ramp (time constant $\tau_L$). During the beginning of the voltage ramp, the OCP circuit is activated, as both conditions at the AND input are true. This is e.g. clearly seen in Fig.3, lower-right graph. But the coil current is still low and hence it is no problem that the circuit is in the over-current state (the switch behaves like a current source). When the coil current starts to be significant, the circuit is already in the normal-on state. Indeed, the pin voltage has fallen close to ground. Hence the overall behaviour is OK.

The switch is loaded with the external coil. When the switch goes off, the coil will free-wheel. The pin voltage rises, the pin capacitance being charged by current delivered by the coil. As previously discussed pin voltage slope control is built in. The switch will not abruptly go off, it will still take some of the coil current and hence the pin voltage will rise less fast. Finally the pin voltage will surpass $V_{DD}$. Actually, the voltage will go on rising until a mechanism is encountered that stops the increase. If nothing is done, this will be at voltage breakdown of the weakest structure. Clearly this must be avoided or, better, this has to happen in a controlled way. The coil current itself will start to decrease as soon as the pin voltage starts to rise. However, the current will not at all have been decreased to zero when the pin voltage surpasses $V_{DD}$.

Another way to cope with the flyback is to make the pin voltage slope sufficiently slow to have the coil discharged itself, i.e. through its series resistance (time constant $\tau_L$), before the pin reaches $V_{DD}$. However, it was found that the slope control circuit would need to be really big (i.e. a lot bigger than the implemented solution), because a big delay would need to be realised.

The purpose of the implemented flyback circuit is to limit the pin voltage to $V_{DD}+V_{FB}$, $V_{DD}$ being the on-chip supply and $V_{FB}$ a controlled voltage value (see Fig. 1). $V_{FB}$ is on the order of 100 mV. It has to be that low in order to limit the pin voltage to a value slightly above $V_{DD}$. Indeed, the maximum supply for this design turns out to be equal to the silicon technology maximum (which of course is no coincidence). A 100 mV violation however is to be acceptable. Note that the flyback feedback loop is much more sensitive than that for the over-current protection.

As soon as the pin voltage exceeds ($V_{DD}$ + $V_{FB}$), the switch is again activated, sinking the coil current and by doing so stopping the pin voltage rise. The loop actually will regulate the pin voltage to be equal to ($V_{DD}$ + $V_{FB}$). $V_{FB}$ is actually implemented by giving the opamp a systematic offset (which is equal to $V_{FB}$). $V_{FB}$ hence does not exist explicitly. The opamp (see Fig.1) has the important feature that when the pin voltage is lower than ($V_{DD}$ + $V_{FB}$) the feedback loop is open, i.e. the loop will not try to put the switch off when he is to be on.

As already mentioned $V_{FB}$ is rather small, typical value is 100 mV. As a result, during discharge the coil can be considered as if almost shorted on itself. The discharge occurs with a time constant $\tau_L$. If $V_{FB}$ had been higher, the discharge occurs with the same $\tau_L$ but the zero current state would be reached significantly faster.

It is important to note that $V_{DDR}$, this is the external $V_{DD}$ to which the relais are connected (see Fig. 1), should not be more than $V_{FB}$ Volt higher than the chip $V_{DD}$. Otherwise, in the switch off, zero current state the flyback circuit would activate the switch in order to try to lower the pin voltage. This requirement is specified through parameter $dV_{DD}$. Some margin is taken with respect to the absolute maximum, which is $V_{FB}$. For the same reason, a dedicated (i.e. only used for that purpose) on-chip metal track is used to connect the chip $V_{DD}$ pad (or pin) to the inputs of the flyback opamp. By doing this, no (DC) current flows through that track, and hence the opamp gets exactly $V_{DD}$ at the input; any IR drop would eat from the $V_{DDR}$ - $V_{DD}$ margin. Still for the same reason one should take care for voltage drops in the PCB tracks.

During flyback, the coil current flows through the driver switch, while the pin voltage is equal to ($V_{DD}$ + $V_{FB}$) . Hence power dissipation is significant, about 10 times higher than the worst case dissipation when a switch is on. However the flyback situation does not last long: only some time constants of the coil.

**Claims**

1. Driver circuit comprising an input, an output and at least one low-ohmic switch, said switch being provided with an input terminal and two output terminals, said driver circuit further comprising a first feedback arrangement in a low-voltage CMOS technology, inputting the voltage of one output terminal of said switch, said first feedback arrangement steering the input terminal of said switch to keep said voltage of said one output terminal within a predefined range, said predefined range being **characterised by** a threshold value.

2. Driver circuit according to claim 1, whereby said first feedback arrangement is operative only when said voltage of said one output terminal reaches said threshold value.

3. Driver circuit according to claim 1 or 2, whereby said first feedback arrangement comprises an active component.

4. Driver circuit according to any of claims 1 to 3, whereby said first feedback arrangement comprises an asymmetric operational amplifier, one input of said operational amplifier being connected to said voltage of said one output terminal and the output of said operational amplifier steering said input terminal of said switch.

5. Driver circuit according to any of claims 1 to 4, whereby said first feedback arrangement comprises means for providing a voltage reference, said voltage reference being used for setting said threshold value.

6. Driver circuit according to any of claims 1 to 5, whereby said low-ohmic switch is made in a low-voltage CMOS technology.

7. Driver circuit according to any of claims 1 to 6, further comprising a second feedback arrangement inputting said voltage of said one output terminal of said switch and steering said input terminal of said switch to keep the voltage slope at said output terminal within a predefined range.

8. Driver circuit according to claim 7, whereby said second feedback arrangement is passive.

9. Driver circuit according to claim 8, whereby said second feedback arrangement comprises a capacitor.

10. Driver circuit according to claim 9, wherein said second feedback arrangement further comprises a resistor.

11. Driver circuit as in any of the previous claims, further comprising a third feedback arrangement steering said input terminal of said switch to keep the current through said switch within a predefined range.

12. Driver circuit as in claim 11, whereby said third feedback arrangement further comprises a logical circuit driving said input terminal of said switch into a low-current state when said driver circuit input and the voltage of said one output terminal indicate a current through said switch outside said predefined range.

13. Driver circuit as in claim 11 or 12, wherein said third feedback arrangement reuses said resistor as in claim 10.

**Fig.1**

**Fig.2**

Fig. 3

Transient Response

□: /d1/on  +: /d1/ga  ×: /pin  ◣: /d1/b
◇: /d1/a  ▫: /d1/ta  ▽: /vdd!

(V)

6.0
5.0
4.0
3.0
2.0
1.0
0.0

9.9980m  10.003m  10.008m  10.013m  10.018m
time ( s )

◁: /d1/out

34.10m
33.70m
33.30m

(A)

△: /d1/M6/S

7.0u
3.0u
-1.0u

(A)

9.9980m  10.003m  10.008m  10.013m  10.018m
time ( s )

2.0
1.0
0.0
-1.0

dVp/dt, in V/us

9.9980m  10.003m  10.008m  10.013m  10.018m

Transient Response

□: VT

6.0
3.0
0.0

(V)

▫: VT

5.0
2.0
-1.0

(V)

9.9980m  10.003m  10.008m  10.013m  10.018m
time ( s )

Fig. 4

8

**European Patent Office**

## PARTIAL EUROPEAN SEARCH REPORT

**Application Number**

which under Rule 45 of the European Patent Convention EP 04 44 7067
shall be considered, for the purposes of subsequent
proceedings, as the European search report

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 627 818 A (ST MICROELECTRONICS SRL) 7 December 1994 (1994-12-07) * abstract; figure 3 * ----- | 1-3,7-9 | H03K19/003 |
| X | US 2002/181180 A1 (BAUM DAVID R ET AL) 5 December 2002 (2002-12-05) * paragraph [0070], figure 10 * ----- | 1-6 | |
| A | US 4 622 482 A (GANGER JEFFREY D) 11 November 1986 (1986-11-11) * abstract * ----- | 1-9 | |
| A | US 6 281 730 B1 (VU HA CHU) 28 August 2001 (2001-08-28) * abstract; figure 3 * * column 4, line 51 - column 5, line 39 * ----- | 1-9 | |

**TECHNICAL FIELDS SEARCHED (Int.Cl.7)**

H03K

### INCOMPLETE SEARCH

The Search Division considers that the present application, or one or more of its claims, does/do
not comply with the EPC to such an extent that a meaningful search into the state of the art cannot
be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| Munich | 17 June 2004 | Oloff, H |

EPO FORM 1503 03.82 (P04C07)

**European Patent Office**

**INCOMPLETE SEARCH**
**SHEET C**

Application Number

EP 04 44 7067

Claim(s) searched completely:
        1-9

Claim(s) not searched:
        10-13

Reason for the limitation of the search:

Claims 10 to 13 relate to a drive circuit comprising 3 feedback loops.
Technical support in the description can, however, only be found for two
feedback loops - see your present figure 2:
-       the first feedback loop seems to be AND-gate
-       the second feedback loop seems to be the capacitor.

Claim 9 refers to a resistor comprised in the second feedback loop. Such
a resistor could, however, not be identified in the technical description
of the present invention. The resistor R in present figure 2 seems to be
an input device being useful even if no feedback loop would be provided
at all and to cooperate with the AND-gate to provide in input current for
the current mirror configuration when the switch OCP_sw is conducting.

The scope of the claims 9 to 13 is therefore highly obscure, such that no
search could be carried out on the subject-matter of these claims.

**ANNEX TO THE EUROPEAN SEARCH REPORT
ON EUROPEAN PATENT APPLICATION NO.**

EP 04 44 7067

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2004

| Patent document cited in search report | | Publication date | Patent family member(s) | | Publication date |
|---|---|---|---|---|---|
| EP 0627818 | A | 07-12-1994 | EP | 0627818 A1 | 07-12-1994 |
| | | | DE | 69313833 D1 | 16-10-1997 |
| | | | DE | 69313833 T2 | 22-01-1998 |
| | | | JP | 7107773 A | 21-04-1995 |
| | | | US | 5469094 A | 21-11-1995 |
| US 2002181180 | A1 | 05-12-2002 | NONE | | |
| US 4622482 | A | 11-11-1986 | NONE | | |
| US 6281730 | B1 | 28-08-2001 | NONE | | |

EPO FORM P0459

For more details about this annex : see Official Journal of the European Patent Office, No. 12/82